# EUROPÄISCHE PATENTSCHRIFT

(11) **EP 2 596 534 B1**
(45) Veröffentlichungstag und Bekanntmachung des Hinweises auf die Patenterteilung: **30.08.2017**
(21) Anmeldenummer: 11739022.9
(22) Anmeldetag: 15.07.2011
(51) Int. Cl.: H01L 33/38, H01L 33/58, H01L 33/60, H01L 25/075, H01L 33/46, G02F 1/1335, H01L 33/40

(54) **STRAHLUNGSEMITTIERENDES BAUELEMENT UND VERFAHREN ZUR HERSTELLUNG VON STRAHLUNGSEMITTIERENDEN BAUELEMENTEN**
RADIATION-EMITTING COMPONENT AND METHOD FOR PRODUCING RADIATION-EMITTING COMPONENTS
COMPOSANT ÉMETTEUR DE RAYONNEMENT, ET PROCÉDÉ DE FABRICATION DE COMPOSANTS ÉMETTEURS DE RAYONNEMENT

(30) Priorität: 23.07.2010 DE 102010032041
(43) Veröffentlichungstag der Anmeldung: 29.05.2013
(73) Patentinhaber: OSRAM Opto Semiconductors GmbH, 93055 Regensburg (DE)
(72) Erfinder: WEIDNER, Karl, 81245 München (DE); RAMCHEN, Johann, 93077 Bad Abbach (DE); KALTENBACHER, Axel, 93098 Mintraching (DE); WEGLEITER, Walter, 93152 Nittendorf (DE); BARCHMANN, Bernd, 93059 Regensburg (DE); GRUBER, Stefan, 93077 Bad Abbach (DE); BOGNER, Georg, 93138 Lappersdorf (DE)
(74) Vertreter: Epping - Hermann - Fischer
(86) Internationale Anmeldenummer: PCT/EP2011/062157
(87) Internationale Veröffentlichungsnummer: WO 2012/010519

(56) Entgegenhaltungen:
- EP-A2- 1 367 656
- WO-A1-01/07828
- WO-A1-01/61765
- WO-A1-2009/093498
- WO-A1-2009/107661
- DE-A1-102008 014 094
- US-A1- 2007 086 211
- US-A1- 2008 006 840
- US-A1- 2010 032 707

## Beschreibung

Die vorliegende Anmeldung betrifft ein strahlungsemittierendes Bauelement sowie ein Verfahren zur Herstellung von strahlungsemittierenden Bauelementen.

Diese Patentanmeldung beansprucht die Priorität der deutschen Patentanmeldung 10 2010 032 041.2.

Beispielsweise für die Hinterleuchtung von Anzeigevorrichtungen wie Flüssigkristall-Displays (LCDs) oder die Einkopplung in Lichtleiter ist es günstig, wenn die von den strahlungsemittierenden Bauelementen emittierte Strahlung in seitlicher Richtung, also parallel zu einer Montageebene der Bauelemente, abgestrahlt wird. Hierfür werden oftmals vergleichsweise komplizierte externe Optiken verwendet, die die von den strahlungsemittierenden Bauelementen geeignet umlenken. Patentdokumente WO2009093498 A1, WO2009107661 A1 und WO0107828 A1 beschreiben Bauelemente mit den oben genannten Eigenschaften. Patentdokument US20100032707 beschreibt ein Bauelement bei dem die elektrische Zuleitung zu dem Bauelement durch eine Öffnung in einer Auskoppelschicht realisiert ist. Eine Aufgabe ist es, ein strahlungsemittierendes Bauelement anzugeben, das in seitlicher Richtung Strahlung emittiert und kompakt ausgebildet ist. Weiterhin soll ein Verfahren angegeben werden, mit dem strahlungsemittierende Bauelemente vereinfacht und zuverlässig hergestellt werden können.

Diese Aufgaben werden durch den Gegenstand der unabhängigen Patentansprüche gelöst. Weitere Ausgestaltungen und Zweckmäßigkeiten sind Gegenstand der abhängigen Patentansprüche.

Ein strahlungsemittierendes Bauelement gemäß einer Ausführungsform weist unter anderem einen Halbleiterchip auf, der eine erste Hauptfläche, eine der ersten Hauptfläche gegenüber liegende zweite Hauptfläche und einen zur Erzeugung von Strahlung vorgesehenen aktiven Bereich aufweist. Das Bauelement umfasst weiterhin einen Träger, an dem der Halbleiterchip seitens der zweiten Hauptfläche befestigt ist. Auf der ersten Hauptfläche des Halbleiterchips ist eine Auskoppelschicht angeordnet. Die Auskoppelschicht bildet eine in lateraler Richtung von dem Halbleiterchip beabstandete, zur Auskopplung der Strahlung aus dem Bauelement vorgesehene, seitliche Auskoppelfläche, wobei in der Auskoppelschicht eine sich zum Halbleiterchip hin verjüngende Ausnehmung ausgebildet ist, die im Betrieb des Bauelements aus der ersten Hauptfläche austretende Strahlung in Richtung der seitlichen Auskoppelfläche umlenkt. Mittels der Ausnehmung in der Auskoppelschicht erfolgt also eine Umlenkung der Strahlung in eine laterale Richtung. Unter einer lateralen Richtung wird im Rahmen der Anmeldung eine Richtung verstanden, die parallel zu einer Haupterstreckungsebene des aktiven Bereichs des Halbleiterchips verläuft.

In lateraler Richtung ist die Auskoppelschicht zweckmäßigerweise durch die seitliche Auskoppelfläche begrenzt.

Die Ausnehmung ist vorzugsweise von der Auskoppelfläche beabstandet. In Aufsicht auf das strahlungsemittierende Bauelement überlappt die Ausnehmung vorzugsweise mit dem Halbleiterchip.

Die erste Hauptfläche des Halbleiterchips bildet für den Halbleiterchip vorzugsweise eine Hauptstrahlungsaustrittsfläche. Das heißt, vorzugsweise tritt mindestens 50 % der im Halbleiterchip erzeugten Strahlung durch die erste Hauptfläche aus dem Halbleiterchip aus. Je höher der Anteil der aus der ersten Hauptfläche austretenden Strahlung ist, desto größer ist derjenige Strahlungsanteil, der mittels der Ausnehmung gezielt in laterale Richtung umgelenkt und nachfolgend aus der seitlichen Auskoppelfläche austreten kann. Es hat sich herausgestellt, dass sich mit einem überwiegend in vertikaler Richtung, also in einer senkrecht zur Haupterstreckungsebene des aktiven Bereichs verlaufenden Richtung, emittierenden Halbleiterchip eine Auskopplung in lateraler Richtung vereinfacht und zuverlässig steuerbar erzielen lässt.

In der erfindungsgemäßen Ausgestaltung ist der Halbleiterchip in lateraler Richtung zumindest bereichsweise, vorzugsweise entlang des gesamten Umfangs, von einer Reflektorschicht umgeben. Mittels der Reflektorschicht kann der Anteil der Strahlung, der aus der ersten Hauptfläche des Halbleiterchips austritt, weitergehend erhöht werden. Weiterhin kann in der Auskoppelschicht verlaufende Strahlung an der Reflektorschicht reflektiert werden und nachfolgend aus der Auskoppelfläche aus dem Bauelement austreten.

Weiterhin ist die Reflektorschicht elektrisch isolierend. Die Gefahr eines elektrischen Kurzschlusses des Halbleiterchips ist dadurch weitestgehend verringert. Insbesondere kann die Reflektorschicht zumindest bereichsweise, oder weitergehend entlang des gesamten Umfangs, unmittelbar an den Halbleiterchip, insbesondere an den aktiven Bereich, angrenzen.

In einer bevorzugten Ausgestaltung ist auf einer der Reflektorschicht abgewandten Seite der Auskoppelschicht eine weitere Reflektorschicht angeordnet. Die Auskoppelschicht ist in diesem Fall also zwischen zwei Reflektorschichten angeordnet. Mittels der Reflektorschichten kann vermieden werden, dass in die Auskoppelschicht eingekoppelte Strahlung in vertikaler Richtung, also in einer senkrecht zur lateralen Richtung verlaufenden Richtung, aus dem Bauelement austritt. Die Reflektorschicht und/oder die weitere Reflektorschicht können beispielsweise einen Kunststoff enthalten, der reflektierend ausgebildet ist. Vorzugsweise ist der Kunststoff mit Partikeln zur Steigerung der Reflektivität versehen. Beispielsweise eignet sich ein Silikon, das mit Partikeln gefüllt ist, beispielsweise mit Titandioxidpartikeln.

Alternativ oder ergänzend kann die Reflektorschicht auch eine Schicht mit metallischem Charakter enthalten. Unter metallischem Charakter wird im Zweifel verstanden, dass die Schicht ein Metall oder eine metallische Legierung aufweist und weiterhin eine über einen vom Auftreffwinkel der Strahlung weitgehend winkelunabhängige hohe Reflektivität aufweist.

Weiterhin bevorzugt verlaufen die Reflektorschicht und die weitere Reflektorschicht zumindest bereichsweise, insbesondere in einem Bereich außerhalb der Ausnehmung, parallel zueinander. Eine Führung der Strahlung in Richtung der seitlichen Auskoppelfläche wird so vereinfacht.

In einer weiteren bevorzugten Ausgestaltung ist auf der Auskoppelschicht eine erste Kontaktstruktur ausgebildet, die den Halbleiterchip durch die Ausnehmung in der Auskoppelschicht hindurch seitens der ersten Hauptfläche elektrisch kontaktiert. Die erste Kontaktstruktur dient der externen elektrischen Kontaktierung des Bauelements.

Die erste Kontaktstruktur kann auch mehrschichtig ausgebildet sein. Insbesondere kann eine dem Halbleiterchip zugewandte Schicht der ersten Kontaktstruktur die weitere Reflektorschicht bilden.

Auf der dem Halbleiterchip abgewandten Seite weist die erste Kontaktstruktur vorzugsweise eine Schicht auf, zu der vereinfacht eine Lötverbindung hergestellt werden kann. Beispielsweise eignet sich hierfür ein Metall wie Gold, Nickel oder Zinn oder eine metallische Legierung mit zumindest einem der genannten Materialien.

Zweckmäßigerweise weist das Bauelement weiterhin eine zweite Kontaktstruktur zur elektrischen Kontaktierung des Halbleiterchips auf. Über die erste Kontaktstruktur und die zweite Kontaktstruktur können im Betrieb des Bauelements Ladungsträger von unterschiedlichen Seiten in den aktiven Bereich injiziert werden und dort unter Emission von Strahlung rekombinieren.

Insbesondere kann die zweite Kontaktstruktur zur elektrischen Kontaktierung des Halbleiterchips seitens der zweiten Hauptfläche vorgesehen sein. In diesem Fall schließen die erste Kontaktstruktur und die zweite Kontaktstruktur vorzugsweise das Bauelement in vertikaler Richtung ab.

In einer bevorzugten Ausgestaltung ist die Ausnehmung in Aufsicht auf das Bauelement trichterförmig ausgebildet. Insbesondere kann die Ausnehmung rotationssymmetrisch oder zumindest weitgehend rotationssymmetrisch ausgebildet sein. Weiterhin kann die Ausnehmung mittig zum Halbleiterchip angeordnet sein. "Mittig" bedeutet in diesem Zusammenhang, dass eine in vertikaler Richtung verlaufende Achse der Ausnehmung durch den Schwerpunkt des Halbleiterchips oder zumindest innerhalb eines Bereichs um den Schwerpunkt, der einen Radius von höchstens 10 % der maximalen lateralen Ausdehnung des Halbleiterchips aufweist, verläuft. Auf diese Weise ist vereinfacht erzielt, dass das Bauelement in lateraler Richtung eine gleichmäßige räumliche Abstrahlcharakteristik aufweist.

In einer bevorzugten Weiterbildung ist die seitliche Auskoppelfläche in Aufsicht auf das Bauelement zumindest bereichsweise gekrümmt, vorzugsweise von außen gesehen konvex gekrümmt. Insbesondere kann die Auskoppelfläche elliptisch oder rund ausgebildet sein. Eine runde Auskoppelfläche eignet sich, insbesondere in Verbindung mit einer in Aufsicht auf das Bauelement trichterförmig und mittig zum Halbleiterchip angeordneten Ausnehmung für eine lateral gleichmäßige Abstrahlung des Bauelements.

Das Bauelement kann auch mehr als nur einen Halbleiterchip aufweisen. In diesem Fall ist vorzugsweise jedem Halbleiterchip zumindest eine Ausnehmung zugeordnet, die sich in Richtung des jeweiligen Halbleiterchips verjüngt.

Weiterhin kann eine Mehrzahl von Bauelementen mit zumindest einem der obigen Merkmale eine Bauelementanordnung bilden.

Gemäß einer ersten Ausgestaltungsvariante sind zumindest ein erstes Bauelement und ein zweites Bauelement in vertikaler Richtung übereinander angeordnet.

In einer ersten Weiterbildung weisen das erste und das zweite Bauelement jeweils auf der dem Halbleiterchip abgewandten Seite der jeweiligen Auskoppelschicht eine erste Kontaktstruktur und auf der der ersten Kontaktstruktur gegenüberliegenden Seite des Bauelements eine zweite Kontaktstruktur auf, wobei die erste Kontaktstruktur des ersten Bauelements weiterhin bevorzugt mit der zweiten Kontaktstruktur des zweiten Bauelements elektrisch leitend verbunden ist. Das erste Bauelement und das zweite Bauelement können somit elektrisch zueinander in Serie verschaltet sein.

In einer alternativen Weiterbildung weisen das erste und das zweite Bauelemente jeweils eine erste Kontaktstruktur und eine zweite Kontaktstruktur auf, die zur Injektion von Ladungsträgern in den aktiven Bereich aus entgegengesetzten Richtungen vorgesehen sind, wobei sich die erste Kontaktstruktur und die zweite Kontaktstruktur in vertikaler Richtung jeweils durch den Träger und durch die Auskoppelschicht hindurch erstrecken.

Insbesondere können sich die erste Kontaktstruktur und/oder die zweite Kontaktstruktur jeweils in vertikaler Richtung vollständig durch das jeweilige Bauelement hindurch erstrecken. Die Kontaktstrukturen können somit jeweils auf gegenüberliegenden Seiten des Bauelements einen externen elektrischen Kontakt zur Verfügung stellen. Mittels derartig ausgebildeter Kontaktstrukturen können übereinander angeordnete Bauelemente vereinfacht elektrisch parallel zueinander verschaltet sein.

Gemäß einer alternativen Ausgestaltungsvariante sind zumindest ein erstes Bauelement und ein zweites Bauelement in lateraler Richtung nebeneinander angeordnet. Die Bauelementanordnung weist vorzugsweise Kontaktbahnen auf, die auf gegenüberliegenden Seiten der Bauelemente angeordnet sind und die Bauelemente zumindest teilweise elektrisch parallel zueinander verschalten.

In einer bevorzugten Ausgestaltung sind die Bauelemente zwischen zwei Platten angeordnet, wobei vorzugsweise zumindest eine der Platten für die in den Bauelementen erzeugte Strahlung transparent oder zumindest transluzent ist.

Die durch die jeweiligen Auskoppelflächen der Bauelemente austretende Strahlung kann in zumindest eine der Platten eingekoppelt werden und nachfolgend großflächig aus dieser austreten. Die Platte bildet somit einen flächigen Strahler.

In einer weiteren bevorzugten Ausgestaltung ist zwischen den Platten ein Füllmaterial angeordnet, das die Bauelemente zumindest bereichsweise umgibt. Mittels des Füllmaterials kann der Anteil der Strahlung erhöht werden, der von den Bauelementen emittiert und in die Platten eingekoppelt wird.

In einer weiteren bevorzugten Ausgestaltung ist zumindest eine Seitenfläche der Platten verspiegelt. Die im Betrieb von den Halbleiterchips erzeugte Strahlung kann somit an der verspiegelten Seitenfläche der Platten reflektiert werden und durch eine der anderen Seitenflächen austreten.

Bei einem Verfahren zur Herstellung einer Mehrzahl von strahlungsemittierenden Bauelementen wird gemäß einer Ausführungsform eine Mehrzahl von Halbleiterchips auf einem Träger angeordnet. Eine Reflektorschicht wird in die Zwischenräume zwischen den Halbleiterchips aufgebracht. Eine Auskoppelschicht wird ausgebildet, wobei die Auskoppelschicht Ausnehmungen aufweist, in denen jeweils ein Halbleiterchip freigelegt ist und die sich zum Halbleiterchip hin verjüngen. Zum Vereinzeln in die Mehrzahl von Bauelementen wird die Auskoppelschicht durchtrennt und jedes Bauelement weist zumindest einen Halbleiterchip und eine Ausnehmung in der Auskoppelschicht auf.

Das Verfahren wird vorzugsweise in der Reihenfolge der obigen Aufzählung durchgeführt. Es sind aber auch Ausgestaltungen denkbar, in denen eine abweichende Reihenfolge der Herstellungsschritte zweckmäßig ist.

Mittels der Reflektorschicht kann der Träger mit den Halbleiterchips zumindest teilweise eingeebnet werden. Die Auskoppelschicht verläuft somit zumindest weitgehend in einer Ebene.

In einer Ausgestaltung werden die Ausnehmungen mittels kohärenter Strahlung ausgebildet. Insbesondere eignet sich Laserstrahlung. Alternativ oder ergänzend kann auch ein Ätzverfahren Anwendung finden.

In einer alternativen Ausgestaltung wird die Auskoppelschicht bereits so aufgebracht, dass sie die Ausnehmungen aufweist. Dies kann beispielsweise mittels einer den Ausnehmungen entsprechend geformten Gießform erfolgen. Die Gießform kann beispielsweise mittels eines Gießverfahrens, eines Spritzgießverfahrens oder eines Spritzpressverfahrens befüllt werden.

Die Ausnehmung bildet vorzugsweise eine Seitenfläche, an der die in dem Bauelement erzeugte Strahlung reflektiert wird.

Ein Neigungswinkel der Seitenfläche beträgt relativ zur lateralen Ebene vorzugsweise zwischen einschließlich 30° und einschließlich 60°.

Das beschriebene Verfahren ist zur Herstellung eines weiter oben beschriebenen Bauelements besonders geeignet. Im Zusammenhang mit dem Bauelement oder der Bauelementanordnung beschriebene Merkmale können somit auch für das Verfahren herangezogen werden oder umgekehrt.

Weitere Merkmale, Ausgestaltungen und Zweckmäßigkeiten ergeben sich aus der folgenden Beschreibung der Ausführungsbeispiele in Verbindung mit den Figuren.

Es zeigen:
Die Figuren 1A und 1B ein erstes Ausführungsbeispiel für ein schaltungsemittierendes Bauelement in schematischer Aufsicht (Figur 1B) und zugehöriger Schnittansicht (Figur 1A);
Figur 2 ein Ausführungsbeispiel für einen Halbleiterchip für ein strahlungsemittierendes Bauelement;
Figur 3 ein zweites Ausführungsbeispiel für ein strahlungsemittierendes Bauelement in schematischer Aufsicht;
Figur 4 ein drittes Ausführungsbeispiel für ein strahlungsemittierendes Bauelement in schematischer Schnittansicht;
die Figuren 5A und 5B ein viertes Ausführungsbeispiel für ein strahlungsemittierendes Bauelement in schematischer Aufsicht (Figur 5B) und zugehöriger Schnittansicht (Figur 5A);
Figur 6 ein erstes Ausführungsbeispiel für eine Bauelementanordnung in schematischer Schnittansicht;
Figur 7 ein zweites Ausführungsbeispiel für eine Bauelementanordnung in schematischer Schnittansicht;
Figur 8 ein drittes Ausführungsbeispiel für eine Bauelementanordnung in schematischer Schnittansicht;
Figur 9 ein viertes Ausführungsbeispiel für eine Bauelementanordnung in schematischer Schnittansicht; und
die Figuren 10A bis 10F ein Ausführungsbeispiel für ein Verfahren zur Herstellung eines strahlungsemittierenden Bauelements anhand von schematisch in perspektivischer Darstellung gezeigten Zwischenschritten.

Gleiche, gleichartige oder gleich wirkende Elemente sind in den Figuren mit denselben Bezugszeichen versehen.

Die Figuren und die Größenverhältnisse der in den Figuren dargestellten Elemente untereinander sind nicht als maßstäblich zu betrachten. Vielmehr können einzelne Elemente, insbesondere Schichtdicken, zur besseren Darstellbarkeit und/oder zum besseren Verständnis übertrieben groß dargestellt sein.

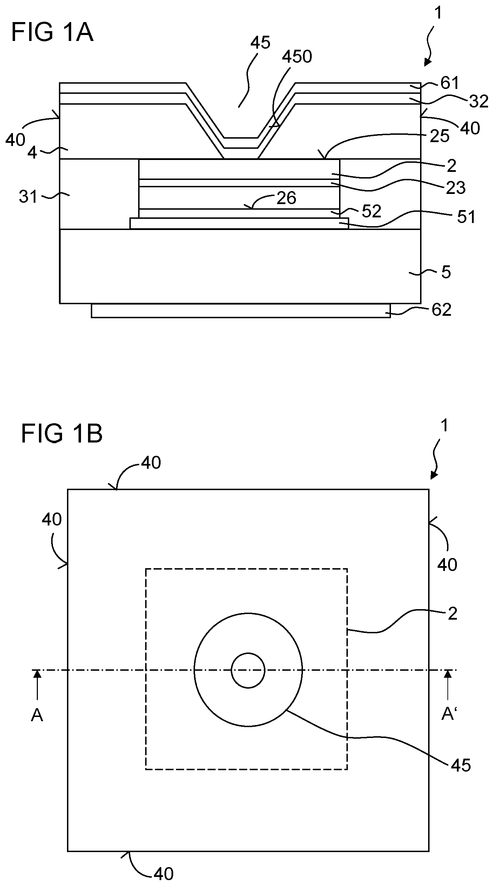

Das in den Figuren 1A (Schnittansicht entlang der Linie AA') und 1B gezeigte erste Ausführungsbeispiel eines strahlungsemittierenden Bauelements 1 weist einen Halbleiterchip 2 auf, der auf einem Träger 5 angeordnet ist.

Der Halbleiterchip 2 ist mittels einer Montageschicht 52 auf einer Montagefläche 51 des Trägers 5 befestigt. Für die Montageschicht eignet sich insbesondere eine Lotschicht oder eine Klebeschicht.

Der Halbleiterchip 2 weist eine erste Hauptfläche 25 und eine der ersten Hauptfläche gegenüberliegende zweite Hauptfläche 26 auf. Zwischen der ersten Hauptfläche 25 und der zweiten Hauptfläche 26 ist ein zur Erzeugung von Strahlung vorgesehener aktiver Bereich 23 ausgebildet.

In lateraler Richtung, also in einer entlang einer Haupterstreckungsebene des aktiven Bereichs 23 verlaufenden Richtung, ist der Halbleiterchip 2 vollständig von einer Reflektorschicht 31 umgeben. Die Reflektorschicht 31 grenzt unmittelbar an den Halbleiterchip 2 an und ist bei der Herstellung an diesen angeformt.

Mittels der Reflektorschicht 31 wird im aktiven Bereich 23 im Betrieb erzeugte Strahlung, die in laterale Richtung abgestrahlt wird und aus dem Halbleiterchip 2 in lateraler Richtung austreten würde, in den Halbleiterchip 2 zurückreflektiert und kann nachfolgend aus der ersten Hauptfläche 25 des Halbleiterchips austreten. Mittels der Reflektorschicht 31 kann somit die insgesamt aus der ersten Hauptfläche 25 des Halbleiterchips austretende Strahlungsleistung erhöht werden.

Die Dicke der Reflektorschicht 31, also die Ausdehnung der Reflektorschicht in vertikaler Richtung, ist derart ausgebildet, dass die Reflektorschicht 31 zumindest den aktiven Bereich 23 bedeckt. Die Reflektorschicht 31 muss in vertikaler Richtung jedoch nicht notwendigerweise mit der ersten Hauptfläche 25 des Halbleiterchips 2 bündig abschließen.

Die Reflektorschicht 31 ist vorzugsweise elektrisch isolierend ausgebildet. Insbesondere kann die Reflektorschicht einen Kunststoff enthalten, der zur Steigerung der Reflektivität mit Füllpartikeln versehen sein kann. Beispielsweise kann die Reflektorschicht 31 eine Silikonschicht sein, die mit Titandioxidpartikeln gefüllt ist. Eine derartige Reflektorschicht kann im sichtbaren Spektralbereich eine Reflektivität von 85 % oder mehr, beispielsweise 95 % aufweisen.

Auf der ersten Hauptfläche 25 des Halbleiterchips 2 ist eine Auskoppelschicht 4 ausgebildet. In lateraler Richtung erstreckt sich die Auskoppelschicht 4 über den Halbleiterchip 2 hinaus und bedeckt auch die Reflektorschicht 31.

In lateraler Richtung ist die Auskoppelschicht von einer seitlichen Auskoppelfläche 40 begrenzt, die für die Auskopplung der im aktiven Bereich 23 erzeugten Strahlung aus dem Bauelement 1 vorgesehen ist. Weiterhin begrenzt die seitliche Auskoppelfläche das Bauelement 1 in lateraler Richtung in diesem Ausführungsbeispiel in vertikaler Richtung vollständig. Die seitliche Auskoppelschicht kann das Bauelement 1 in lateraler Richtung aber auch nur bereichsweise begrenzen. Beispielsweise kann der Träger 5 in lateraler Richtung über die seitliche Auskoppelschicht hinausragen.

In der Auskoppelschicht 4 ist eine Ausnehmung 45 ausgebildet, die sich in vertikaler Richtung durch die Auskoppelschicht hindurch erstreckt. Die Ausnehmung 45 weist eine Seitenfläche 450 auf, die relativ zur lateralen Ebene geneigt ist. An dieser Seitenfläche kann im aktiven Bereich 23 erzeugte und aus der ersten Hauptfläche 25 des Halbleiterchips 2 austretende Strahlung in Richtung der seitlichen Auskoppelfläche 40 umgelenkt werden. Die Seitenfläche 450 grenzt an den Halbleiterchip an. Die aus dem Halbleiterchip 2 austretende Strahlung wird also unmittelbar in die Auskoppelschicht 4 eingekoppelt und dort beim Auftreffen auf die Ausnehmung 45 umgelenkt.

Die Seitenfläche 450 schließt zur ersten Hauptfläche 25 vorzugsweise einen Winkel zwischen einschließlich 30° und einschließlich 60° ein, bevorzugt zwischen einschließlich 35° und einschließlich 55°.

Auf der dem Halbleiterchip 2 abgewandten Seite der Auskoppelschicht 4 ist eine weitere Reflektorschicht 32 angeordnet. Die weitere Reflektorschicht 32 bedeckt zumindest die Seitenfläche 450 der Ausnehmung 45 und dient der verbesserten Strahlungsumlenkung in Richtung der seitlichen Auskoppelfläche 40. In einem and die Auskoppelfläche 40 angrenzenden Bereich verlaufen die Reflektorschicht 31 und die weitere Reflektorschicht 32 parallel zueinander.

In diesem Ausführungsbeispiel grenzt die weitere Reflektorschicht 32 im Bereich der Ausnehmung 45 an den Halbleiterchip 2 an. Auf der dem Halbleiterchip 2 abgewandten Seite der weiteren Reflektorschicht 32 ist eine erste Kontaktstruktur 61 angeordnet, die einen externen elektrischen Kontakt für das Bauelement 1 bildet. Auf der der ersten Kontaktstruktur gegenüberliegenden Seite ist eine zweite Kontaktstruktur 62 ausgebildet. Im Betrieb des strahlungsemittierenden Bauelements können über die erste Kontaktstruktur 61 und die zweite Kontaktstruktur 62 Ladungsträger von verschiedenen Seiten in den aktiven Bereich 23 des Halbleiterchips 2 injiziert werden und dort unter Emission von Strahlung rekombinieren.

In diesem Ausführungsbeispiel ist die weitere Reflektorschicht 32 elektrisch leitfähig ausgebildet. Vorzugsweise weist die weitere Reflektorschicht metallischen Charakter auf und enthält ein Metall oder eine metallische Legierung mit zumindest einem Metall, das für die aktiven Bereich zu erzeugende Strahlung eine hohe Reflektivität aufweist. Im sichtbaren Spektralbereich weisen beispielsweise Aluminium, Silber, Rhodium, Palladium und Chrom eine hohe Reflektivität auf. Für den infraroten Spektralbereich eignet sich beispielsweise Gold.

Die erste Kontaktstruktur 61 und die zweite Kontaktstruktur 62 sind zumindest auf der dem Halbleiterchip 2 abgewandten Seite jeweils so ausgebildet, dass das Bauelement vereinfacht extern elektrisch kontaktierbar ist, beispielsweise mittels einer Lötverbindung. Vorzugsweise enthalten die erste Kontaktstruktur und die zweite Kontaktstruktur ein Metall, beispielsweise Silber, Aluminium, Palladium, Nickel, Platin, Gold oder Titan oder eine metallische Legierung mit zumindest einem der genannten Materialien.

Die elektrische Kontaktierung des Halbleiterchips seitens der zweiten Hauptfläche 26 erfolgt in diesem Ausführungsbeispiel durch den Träger 5 hindurch. Der Träger 5 weist vorzugsweise eine hohe elektrische Leitfähigkeit und weiterhin eine hohe thermische Leitfähigkeit auf. Insbesondere kann der Träger ein Metall, beispielsweise Kupfer, enthalten oder aus einem Metall bestehen. Der Träger 5 kann beispielsweise aus einem Metallblech, beispielsweise einem Kupferblech hergestellt sein. Der Träger kann völlig unstrukturiert sein und ist somit besonders einfach und kostengünstig herstellbar.

Von dem gezeigten Ausführungsbeispiel abweichend kann der Träger 5 für eine direkte externe Kontaktierung vorgesehen sein, so dass der Träger 5 selbst die zweite Kontaktstruktur bilden kann. Eine zusätzliche Schicht zur Ausbildung der zweiten Kontaktstruktur ist in diesem Fall nicht erforderlich.

In Aufsicht auf das Bauelement 1 ist die Ausnehmung 45 trichterförmig ausgebildet, wobei der Trichter rotationssymmetrisch ausgestaltet ist. Weiterhin ist die Ausnehmung 45 mittig zum Halbleiterchip 2 angeordnet. So kann ein in lateraler Richtung gleichmäßiges Austreten der Strahlung durch die seitlichen Auskoppelflächen 40 erfolgen. Die Abstrahlung erfolgt in der lateralen Ebene in jede Richtung, also in 360° um den Halbleiterchip. Je nach vorgegebener Abstrahlcharakteristik für das Bauelement kann jedoch auch eine andere Positionierung relativ zum Halbleiterchip 2 und/oder eine von einer Rotationssymmetrie abweichende Ausgestaltung der Ausnehmung 45 zweckmäßig sein.

Das beschriebene Bauelement 1 eignet sich insbesondere aufgrund seiner seitlichen Abstrahlung und der kompakten Bauform besonders für eine direkte Hinterleuchtung einer Anzeigevorrichtung, etwa eines LCDs (Liquid Crystal Display) oder für eine Einkopplung in einen Lichtleiter.

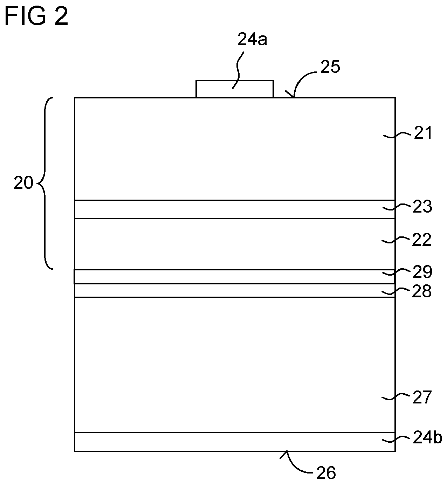

In Figur 2 ist in schematischer Schnittansicht ein Ausführungsbeispiel für einen Halbleiterchip 2 gezeigt, der für die vorstehend und nachfolgend beschriebenen Bauelemente besonders geeignet ist.

Der Halbleiterchip 2 weist einen Halbleiterkörper 20 mit einer Halbleiterschichtenfolge auf. Die Halbleiterschichtenfolge, die den Halbleiterkörper 20 bildet, umfasst einen ersten Halbleiterbereich 21 und einen zweiten Halbleiterbereich 22, die zweckmäßigerweise voneinander verschiedene Leitungstypen aufweisen. Zwischen dem ersten Halbleiterbereich und dem zweiten Halbleiterbereich ist ein zur Erzeugung von Strahlung vorgesehener aktiver Bereich 23 ausgebildet.

Der Halbleiterkörper 20 ist auf einem Substrat 27 angeordnet. Das Substrat ist von einem Aufwachssubstrat für die Halbleiterschichtenfolge des Halbleiterkörpers 20 verschieden. Das Substrat 27 dient insbesondere der mechanischen Stabilisierung des Halbleiterkörpers 20. Das Aufwachssubstrat für die Halbleiterschichtenfolge ist hierfür nicht mehr erforderlich. Der Halbleiterchip 2 ist somit frei von dem Aufwachssubstrat. Das Substrat kann beispielsweise ein Halbleitermaterial, etwa Silizium, Germanium oder Galliumarsenid enthalten oder aus einem Halbleitermaterial bestehen.

Ein Halbleiterchip, bei dem das Aufwachssubstrat entfernt ist, wird auch als Dünnfilm-Halbleiterchip bezeichnet.

Ein Dünnfilm-Halbleiterchip, etwa ein Dünnfilm-Leuchtdioden-Chip, kann sich weiterhin im Rahmen der vorliegenden Anmeldung durch mindestens eines der folgenden charakteristischen Merkmale auszeichnen:
- an einer zu einem Trägerelement, z.B. dem Substrat 27, hin gewandten ersten Hauptfläche eines Halbleiterkörpers, der eine Halbleiterschichtenfolge mit einem aktiven Bereich umfasst, insbesondere einer Epitaxieschichtenfolge, ist eine Spiegelschicht aufgebracht oder, etwa als Braggspiegel in der Halbleiterschichtenfolge integriert, ausgebildet, die zumindest einen Teil der in der Halbleiterschichtenfolge erzeugten Strahlung in diese zurückreflektiert;
- die Halbleiterschichtenfolge weist eine Dicke im Bereich von 20µm oder weniger, insbesondere im Bereich von 10 µm auf; und/oder
- die Halbleiterschichtenfolge enthält mindestens eine Halbleiterschicht mit zumindest einer Fläche, die eine Durchmischungsstruktur aufweist, die im Idealfall zu einer annähernd ergodischen Verteilung des Lichtes in der Halbleiterschichtenfolge führt, d.h. sie weist ein möglichst ergodisch stochastisches Streuverhalten auf.

Ein Grundprinzip eines Dünnfilm-Leuchtdiodenchips ist beispielsweise in I. Schnitzer et al., Appl. Phys. Lett. 63 (16), 18. Oktober 1993, 2174 - 2176 beschrieben, deren Offenbarungsgehalt insofern hiermit durch Rückbezug in die vorliegende Anmeldung aufgenommen wird.

Zwischen dem Substrat 27 und dem Halbleiterkörper 20 ist eine Verbindungsschicht 28 angeordnet, mit der der Halbleiterkörper an dem Substrat 27 befestigt ist. Weiterhin ist zwischen dem Halbleiterkörper 20 und dem Substrat 27 eine Spiegelschicht 29 mit vorzugsweise metallischem Charakter ausgebildet, die dafür vorgesehen ist, im aktiven Bereich 23 erzeugte und in Richtung des Substrats 27 abgestrahlte Strahlung zur ersten Hauptfläche hin umzulenken.

Ein Dünnfilm-Halbleiterchip zeichnet sich insbesondere dadurch aus, dass der überwiegende Strahlungsanteil seitens der ersten Hauptfläche austritt, also mindestens 50 % der abgestrahlten Strahlung.

Von dem beschriebenen Ausführungsbeispiel abweichend kann aber beispielsweise auch ein Halbleiterchip Anwendung finden, bei dem das Aufwachssubstrat für die Halbleiterschichtenfolge des Halbleiterkörpers das Substrat bildet. Eine Verbindungsschicht zwischen dem Substrat 27 und dem Halbleiterkörper 20 ist in diesem Fall nicht erforderlich.

Zur elektrischen Kontaktierung weist der Halbleiterchip 2 einen ersten Anschluss 24a auf, der die erste Hauptfläche des Halbleiterchips bildet. Auf der dem ersten Anschluss 24a gegenüber liegenden Seite ist auf der zweiten Hauptfläche 26 des Halbleiterchips ein zweiter Anschluss 24b angeordnet. Der Halbleiterchip ist somit von gegenüber liegenden Seiten extern elektrisch kontaktierbar.

Der Halbleiterchip 2, insbesondere der aktive Bereich 23, enthält vorzugsweise ein III-V-Halbleitermaterial. III-V-Halbleitermaterialien sind zur Strahlungserzeugung im ultravioletten (Alₓ In_{y} Ga_{1-x-y} N) über den sichtbaren (Alₓ In_{y} Ga_{1-x-y} N, insbesondere für blaue bis grüne Strahlung, oder Alₓ In_{y} Ga_{1-x-y} P, insbesondere für gelbe bis rote Strahlung) bis in den infraroten (Alₓ In_{y} Ga_{1-x-y} As) Spektralbereich besonders geeignet. Hierbei gilt jeweils 0 ≤ x ≤ 1, 0 ≤ y ≤ 1 und x + y ≤ 1, insbesondere mit x ≠ 1, y ≠ 1, x ≠ 0 und/oder y ≠ 0. Mit III-V-Halbleitermaterialien, insbesondere aus den genannten Materialsystemen, können weiterhin bei der Strahlungserzeugung hohe interne Quanteneffizienzen erzielt werden.

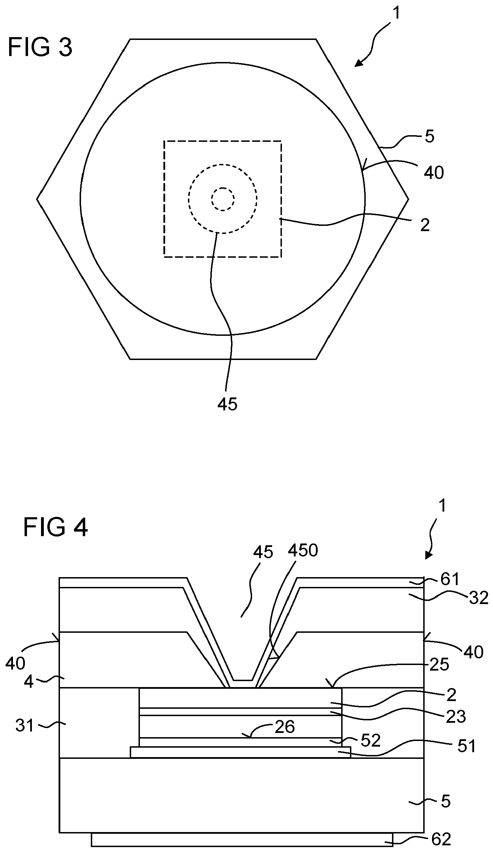

Ein zweites Ausführungsbeispiel für ein strahlungsemittierendes Bauelement ist in Figur 3 anhand einer schematischen Aufsicht dargestellt. Dieses zweite Ausführungsbeispiel entspricht im Wesentlichen dem in Zusammenhang mit den Figuren 1A und 1B beschriebenen ersten Ausführungsbeispiel. Im Unterschied hierzu ist die seitliche Auskoppelfläche 40 in Aufsicht rund ausgebildet. Auf diese Weise wird erzielt, dass an der Ausnehmung 45 in radialer Richtung reflektierte Strahlung vollumfänglich senkrecht auf die seitliche Auskoppelfläche 40 auftrifft und somit mit einer hohen Effizienz aus dem Bauelement 1 ausgekoppelt werden kann.

Der Träger 5 weist im Fall einer solchen runden seitlichen Auskoppelfläche 40 vorzugsweise eine von der der seitlichen Auskoppelfläche abweichende Form auf, in diesem Ausführungsbeispiel in Aufsicht die Form eines regelmäßigen Sechsecks. Auf diese Weise wird erzielt, dass die Bauelemente 1 bei der Herstellung trotz der gekrümmten seitlichen Auskoppelfläche 40 eine Umrandung mit geraden Teilabschnitten aufweisen. Aufgrund solcher gerader Teilabschnitte können die Bauelemente bei der Herstellung vereinfacht vereinzelt werden, beispielsweise mechanisch, etwa mittels Sägens, Spaltens oder Brechens.

Zur weitergehenden Steigerung der Homogenität der Abstrahlcharakteristik in lateraler Richtung kann zusätzlich die erste Hauptfläche 25 des Halbleiterchips in Aufsicht rotationssymmetrisch ausgestaltet sein, so dass die im aktiven Bereich erzeugte Strahlung mit einer rotationssymmetrischen oder zumindest im Wesentlichen rotationssymmetrischen Strahlungsdichte in die Auskoppelschicht 4 eintritt.

Ein drittes Ausführungsbeispiel für ein Bauelement ist in Figur 4 schematisch in Schnittansicht dargestellt. Dieses dritte Ausführungsbeispiel entspricht im Wesentlichen dem im Zusammenhang mit den Figuren 1A und 1B beschriebenen ersten Ausführungsbeispiel. Im Unterschied hierzu grenzt die erste Kontaktstruktur 61 im Bereich der Ausnehmung 45 unmittelbar an den Halbleiterchip 2 an. Die elektrische Kontaktierung des Halbleiterchips erfolgt somit nicht durch die weitere Reflektorschicht 32 hindurch. Diese kann daher auch elektrisch isolierend ausgebildet sein, insbesondere kann die weitere Reflektorschicht 32 gleichartig zur Reflektorschicht 31 ausgebildet sein. Die Auskoppelschicht 4 kann somit auf beiden Seiten zumindest bereichsweise an eine Reflektorschicht angrenzen, die in einfacher Weise, beispielsweise mittels eines Dispensers oder eines Gießverfahrens, herstellbar ist.

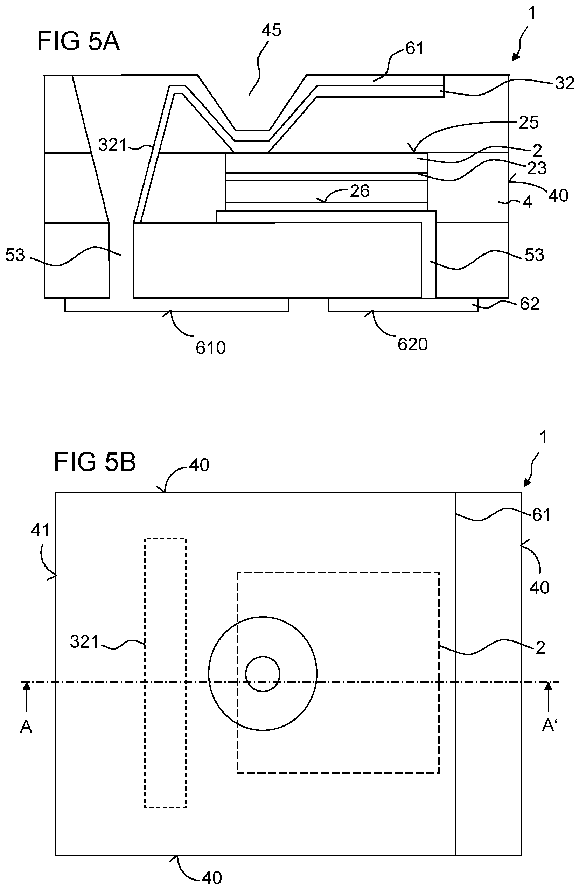

Das in den Figuren 5A und 5B schematisch dargestellte vierte Ausführungsbeispiel für ein Bauelement 1 entspricht im Wesentlichen dem im Zusammenhang mit den Figuren 1A und 1B beschriebenen ersten Ausführungsbeispiel. Im Unterschied hierzu bildet die erste Kontaktstruktur 61 auf der dem Halbleiterchip 2 abgewandten Seite des Trägers 5 eine erste Kontaktfläche 610. Mittels der ersten Kontaktfläche 610 und einer zweiten Kontaktfläche 620 der zweiten Kontaktstruktur 62 ist das strahlungsemittierende Bauelement also mit zwei Kontakten unterseitig kontaktierbar. Die erste Kontaktstruktur 61 und die zweite Kontaktstruktur 62 erstrecken sich jeweils durch Ausnehmungen 53 im Träger 5 hindurch und bilden seitens der ersten Hauptfläche 25 beziehungsweise seitens der zweiten Hauptfläche 26 des Halbleiterchips 2 einen elektrischen Anschluss zum Halbleiterchip.

In diesem Ausführungsbeispiel kann der Träger 5 auch elektrisch isolierend ausgebildet sein. Beispielsweise kann der Träger eine Keramik, etwa Aluminiumnitrid oder Bornitrid, oder einen Kunststoff enthalten oder aus einem solchen Material bestehen. Mittels einer Keramik lässt sich ein Träger herstellen, der eine hohe thermische Wärmeleitfähigkeit aufweist, so dass im Betrieb erzeugte Abwärme effizient aus dem Halbleiterchip 2 abgeführt werden kann.

Weiterhin ist das Bauelement nicht für eine vollumfängliche Abstrahlung vorgesehen, sondern weist exemplarisch nur drei seitliche Auskoppelflächen 40 auf. In Richtung einer weiteren Seitenfläche 41 abgestrahlte Strahlung wird mittels eines Seitenreflektors 321 in Richtung der seitlichen Auskoppelflächen 40 umgelenkt.

Der Seitenreflektor 321 ist in diesem Ausführungsbeispiel mittels eines Bereichs der weiteren Reflektorschicht 32 gebildet, der die Auskoppelschicht 4 durchdringt.

Mittels der Form des Seitenreflektors 321 ist die Abstrahlcharakteristik des Bauelements 1 einstellbar. Beispielsweise kann der Seitenreflektor 321 in Aufsicht U-förmig ausgeführt sein, so dass die Abstrahlung des strahlungsemittierenden Bauelements im Wesentlichen nur noch durch eine seitliche Auskoppelfläche 40 erfolgt.

Weiterhin ist im Unterschied zum ersten Ausführungsbeispiel die Ausnehmung 45 in der Auskoppelschicht 4 vom Schwerpunkt des Halbleiterchips 2 aus gesehen in Richtung der nicht zur Abstrahlung vorgesehenen weiteren Seitenfläche 41 hin verschoben. Eine gerichtete Abstrahlung von der weiteren Seitenfläche weg wird dadurch weitergehend gefördert.

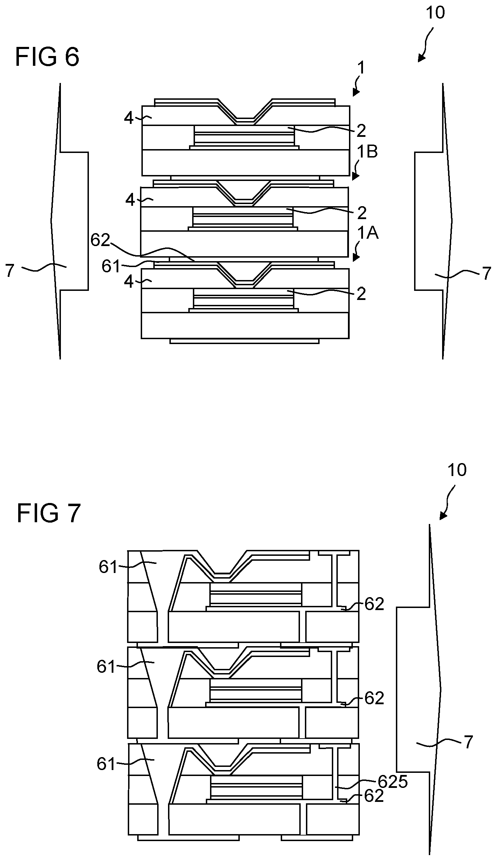

In Figur 6 ist ein erstes Ausführungsbeispiel für eine Bauelementanordnung gezeigt, die eine Mehrzahl von strahlungsemittierenden Bauelementen 1 aufweist, die jeweils wie im Zusammenhang mit den Figuren 1A und 1B beschrieben ausgeführt sind. Die Bauelementanordnung 10 weist exemplarisch drei strahlungsemittierende Bauelemente 1 auf, die in vertikaler Richtung übereinander angeordnet sind. Hierbei ist eine erste Kontaktstruktur 61 eines ersten Bauelements 1A mit einer zweiten Kontaktstruktur 62 eines zweiten Bauelements 1B elektrisch leitend verbunden, beispielsweise mittels einer Verbindungsschicht, etwa einem Lot oder einem elektrisch leitfähiges Klebemittel (nicht explizit dargestellt). Die übereinander angeordneten Bauelemente 1A, 1B sind so ohne Drahtverbindungen elektrisch zueinander in Serie verschaltet. Ein Pfeil 7 veranschaulicht die insgesamt von der Bauelementanordnung 10 in laterale Richtung 10 abgestrahlte Strahlung.

Ein zweites Ausführungsbeispiel für eine Bauelementanordnung ist in Figur 7 schematisch in Schnittansicht dargestellt. Diese Bauelementanordnung 10 weist eine Mehrzahl von Bauelementen 1 auf, die wie im ersten Ausführungsbeispiel in vertikaler Richtung übereinander angeordnet sind. Die Bauelemente 1 entsprechen im Wesentlichen den Bauelementen gemäß dem vierten Ausführungsbeispiel, das im Zusammenhang mit den Figuren 5A und 5B beschrieben ist.

Im Unterschied hierzu weist die zweite Kontaktstruktur 62 der Bauelemente 1 jeweils eine Durchkontaktierung 625 auf. Die Durchkontaktierung erstreckt sich jeweils durch die Auskoppelschicht 4 hindurch. Jedes Bauelement 1 stellt somit eine erste Kontaktstruktur 61 und eine zweite Kontaktstruktur 62 zur Verfügung, die sich in vertikaler Richtung vollständig durch das Bauelement 1 hindurch erstrecken. Die ersten Kontaktstrukturen 61 und die zweiten Kontaktstrukturen 62 aufeinander folgender Bauelemente 1 sind jeweils elektrisch leitend miteinander verbunden, so dass die Bauelemente 1 der Bauelementanordnung 10 elektrisch zueinander parallel verschaltet sind. Mittels der beschriebenen Ausgestaltung der Kontaktstrukturen 61, 62 können in vertikaler Richtung übereinander angeordnete Bauelemente 1 also elektrisch zueinander parallel verschaltet sein, ohne dass hierfür zusätzliche externe elektrische Verbindungsleitungen erforderlich sind.

Die insgesamt emittierte Strahlungsleistung in lateraler Richtung (Pfeil 7) kann also durch eine Stapelung von, insbesondere identisch oder zumindest gleichartig ausgeführten, strahlungsemittierenden Bauelemente in vertikaler Richtung erhöht werden.

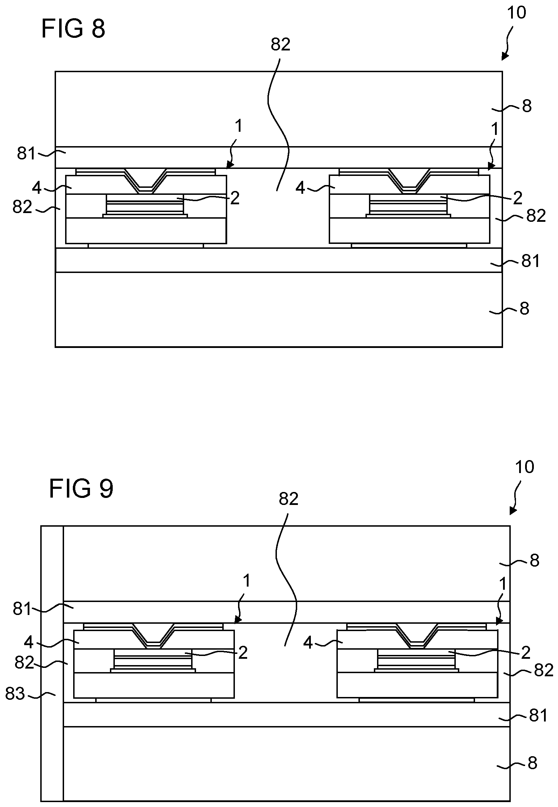

In Figur 8 ist ein drittes Ausführungsbeispiel für eine Bauelementanordnung 10 gezeigt, bei der die Bauelemente 1 im Wesentlichen wie in dem im Zusammenhang mit den Figuren 1A und 1B beschriebenen ersten Ausführungsbeispiel ausgeführt sind.

Die Bauelementanordnung 10 weist eine Mehrzahl von Bauelementen 1 auf, die in lateraler Richtung nebeneinander angeordnet sind.

Die strahlungsemittierenden Bauelemente 1 sind zwischen zwei Platten 8 angeordnet. Mittels Kontaktbahnen 81 sind die Bauelemente 1 elektrisch zueinander parallel verschaltet. Die Kontaktbahnen 81 können beispielsweise jeweils als eine durchgängige, vollflächige transparente oder zumindest transluzente Kontaktschicht ausgebildet sein. Beispielsweise kann die Kontaktbahn ein transparentes leitfähiges Oxid (Transparent Conductive Oxide, TCO) enthalten. Alternativ oder ergänzend können auf den Platten 8 metallische Kontaktbahnen vorgesehen sein, die so dünn sein können, dass sie vom menschlichen Auge aus einem vorgegebenen Abstand nicht mehr wahrgenommen werden. Beispielsweise können die Kontaktbahnen Kupfer enthalten oder aus Kupfer bestehen.

Zwischen den Bauelementen 1 ist ein Füllmaterial 82 angeordnet, das dafür vorgesehen ist aus den Bauelementen 1 emittierte Strahlung in die Platten 8 einzukoppeln. Vorzugsweise weist das Füllmaterial 82 einen Brechungsindex auf, der im Bereich des Brechungsindices der Platten liegt. Im Betrieb der Bauelementanordnung 10 kann die von den Bauelementen 1 erzeugte Strahlung über die Platten 8 ausgekoppelt werden, so dass auf einfache Weise eine Bauelementanordnung mit einer großflächigen Abstrahlfläche realisiert ist.

Das in Figur 9 dargestellte vierte Ausführungsbeispiel für eine Bauelementanordnung entspricht im Wesentlichen dem in Zusammenhang mit Figur 8 beschriebenen dritten Ausführungsbeispiel. Im Unterschied hierzu weist die Bauelementanordnung 10 einen Spiegel 83 auf, der eine Abstrahlung durch eine Seitenfläche der Bauelementanordnung verhindert. Es können auch mehrere Seitenflächen der Bauelementanordnung 10 einen Spiegel 83 aufweisen, so dass die insgesamt aus der Bauelementanordnung 10 durch die nicht verspiegelten Flächen austretende Strahlungsleistung erhöht werden kann. Für den Spiegel eignet sich insbesondere eines der im Zusammenhang mit den Reflektorschichten 31, 32 beschriebenen Materialien.

Von dem beschriebenen Ausführungsbeispiel abweichend kann auch zumindest eine der Platten Vertiefungen aufweisen, in denen die Halbleiterchips angeordnet sind. Seitlich aus den Halbleiterchips austretende Strahlung kann so durch eine Seitenfläche der Vertiefungen in die Platte eingekoppelt werden.

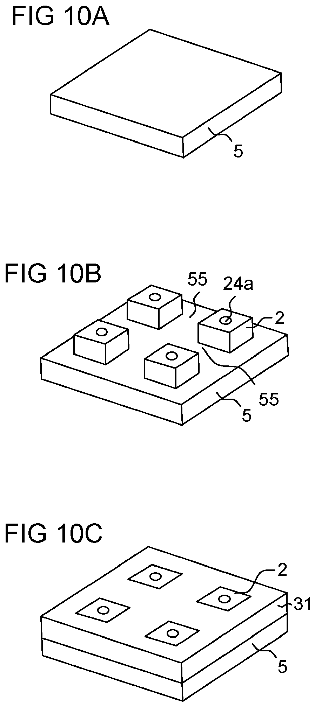

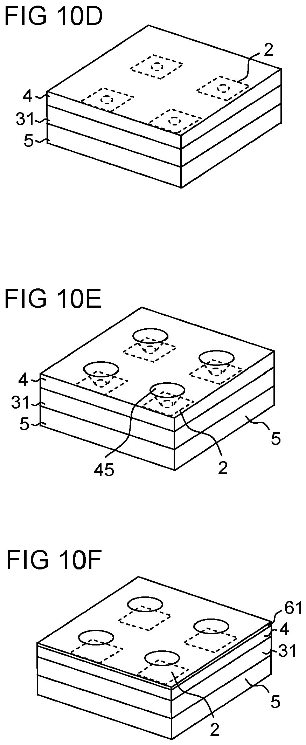

Ein Ausführungsbeispiel für ein Verfahren zur Herstellung von strahlungsemittierenden Bauelementen ist den Figuren 10A bis 10F schematisch anhand von perspektivisch dargestellten Zwischenschritten gezeigt, wobei zur vereinfachten Darstellung nur ein Teil gezeigt ist, aus dem bei der Herstellung ein Bauelement hervorgeht. Die Herstellung ist exemplarisch für ein Bauelement mit vier Halbleiterchips 2 dargestellt. Die Anzahl der Halbleiterchips pro Bauelement ist jedoch in weiten Grenzen frei wählbar. Insbesondere kann das strahlungsemittierende Bauelement 1 auch nur genau einen Halbleiterchip 2 aufweisen.

Wie in Figur 10A dargestellt, wird ein Träger 5 breitgestellt, beispielsweise in Form eines Metallblechs, etwa eines Kupferblechs.

Auf dem Träger 5 werden Halbleiterchips 2 angeordnet (Figur 10B). Auf der dem Träger 5 zugewandten Seite werden die Halbleiterchips 2 elektrisch leitend mit dem Träger 5 verbunden, beispielsweise mittels einer Lotschicht oder einer Klebeschicht (nicht explizit dargestellt). Die Zwischenräume 55 zwischen den Halbleiterchips 2 werden mittels einer Formmasse befüllt, die eine Reflektorschicht 31 bildet (Figur 10C). Mittels der Formmasse wird also der Träger 5 mit den Halbleiterchips 2 eingeebnet. Die Reflektorschicht 31 muss jedoch nicht notwendigerweise bündig mit den Halbleiterchips 2 auf der dem Träger 5 abgewandten Seite abschließen. Insbesondere kann eine vom Träger 5 abgewandte erste Hauptfläche des Halbleiterchips auch zumindest bereichsweise mit der Reflektorschicht bedeckt sein.

Die Abscheidung der Reflektorschicht 31 kann beispielsweise mittels eines Dispensers erfolgen. Alternativ kann auch ein anderes Verfahren Anwendung finden, beispielsweise ein Gießverfahren, ein Spritzgussverfahren oder ein Spritzpressverfahren.

Als Material für die erste Reflektorschicht 31 eignet sich beispielsweise eine mit Titandioxid-Partikeln gefüllte Silikonschicht. Mit zunehmendem Füllgrad kann die Reflektivität der Reflektorschicht erhöht werden, so dass diese 90 % oder mehr, bevorzugt 95 % oder mehr beträgt.

Nachfolgend wird, wie in Figur 10D dargestellt, eine Auskoppelschicht 4 aufgebracht. Die Auskoppelschicht 4 enthält zweckmäßigerweise ein Material, das für die in den Halbleiterchips erzeugte Strahlung transparent oder zumindest transluzent ist. In der Auskoppelschicht kann zur Steuerung der spektralen und/oder räumlichen Abstrahlcharakteristik auch ein Lumineszenzkonversionsmaterial oder ein Diffusormaterial eingebettet sein.

Im Fall eines eingebetteten Lumineszenzkonversionsmaterials kann die in diesem Material im Betrieb entstehende Verlustwärme effizient über die erste Kontaktstruktur 61 und gegebenenfalls über die weitere Reflektorschicht 32 abgeführt werden.

Für die Auskoppelschicht 4 eignet sich insbesondere ein Polymermaterial, beispielsweise ein Silikon, ein Epoxid oder eine Mischung aus einem Silikon und einem Epoxid.
In der Auskoppelschicht 4 werden Ausnehmungen 45 ausgebildet, wobei sich die Ausnehmungen 45 jeweils durch die Auskoppelschicht 4 hindurch zu einem Halbleiterchip 2 erstrecken. Die Ausnehmungen werden derart ausgebildet, dass sie sich zum Halbleiterchip 2 hin verjüngen. Dies kann beispielsweise mittels kohärenter Strahlung, etwa Laserstrahlung erfolgen. Alternativ kann auch ein chemisches Verfahren, etwa ein nasschemisches Ätzverfahren, Anwendung finden.

Davon abweichend kann die Auskoppelschicht 4 auch so aufgebracht werden, dass sie die Ausnehmungen 45 bereits aufweist. Hierfür kann eine Gießform verwendet werden, die den Ausnehmungen entsprechend geformt ist, so dass die Gießform im Bereich der Ausnehmungen an den Halbleiterchip 2 angrenzt.

Das Befüllen der Gießform kann beispielsweise mittels Gießens, Spritzgießens oder Spritzpressens erfolgen.

Wie in Figur 10F dargestellt, wird auf der Auskoppelschicht 4 eine erste Kontaktstruktur 61 ausgebildet, beispielsweise mittels Aufdampfens oder Sputterns.

Vor dem Aufbringen der ersten Kontaktstruktur 61 kann, beispielsweise mittels kohärenter Strahlung, die freigelegte Oberfläche des Halbleiterchips gereinigt werden, so dass eine zuverlässige Kontaktierung erfolgt.

Die erste Kontaktstruktur 61 dient der elektrischen Kontaktierung des Halbleiterchips von der dem Träger 5 abgewandten Seite her. Die erste Kontaktstruktur 61 kann auch mehrschichtig ausgebildet sein, wobei eine der Auskoppelschicht 4 zugewandte erste Schicht als eine weitere Reflektorschicht ausgebildet sein kann. Beispielsweise eignen sich Schichtfolgen wie Titan/Nickel/Palladium/Gold oder Titan/Nickel/Gold.

Erforderlichenfalls kann die an den Halbleiterchip 2 angrenzende Schicht der ersten Kontaktstruktur 61 mittels eines galvanischen Abscheideverfahrens verstärkt werden.

Bei der Herstellung werden mehrere strahlungsemittierende Bauelemente 1 nebeneinander hergestellt. Die Vereinzelung der Bauelemente kann beispielsweise mechanisch, etwa mittels Sägens, Schneidens oder Brechens und/oder chemisch, etwa mittels Ätzen, erfolgen. Auch kohärente Strahlung kann für die Vereinzelung Anwendung finden.

Beim Vereinzeln wird insbesondere die Auskoppelschicht 4 durchtrennt, wobei die Trennflächen die seitlichen Auskoppelflächen 40 des Bauelements 1 bilden können.

Mit dem beschriebenen Verfahren lassen sich auf besonders einfache und zuverlässige Weise strahlungsemittierende Bauelemente herstellen, die im Betrieb Strahlung in lateraler Richtung abstrahlen. Die vertikale Ausdehnung der Auskoppelfläche ist hierbei bei der Herstellung durch geeignete Wahl der Schichtdicke der Auskoppelschicht 4 einstellbar. So können die strahlungsemittierenden Bauelemente 1 in einfacher Weise beispielsweise an einen vorgegebenen Lichtleiter angepasst ausgebildet werden. Auf separate optische Vorrichtungen zur Umlenkung der vom strahlungsemittierenden Bauelement 1 abgestrahlten Strahlung kann verzichtet werden.

Die Erfindung ist nicht durch die Beschreibung anhand der Ausführungsbeispiele beschränkt. Vielmehr umfasst die Erfindung jede Kombination von Merkmalen in den Patentansprüchen.

## Patentansprüche

1. Strahlungsemittierendes Bauelement (1) mit
- einem Halbleiterchip (2), der eine erste Hauptfläche (25), eine der ersten Hauptfläche (25) gegenüberliegende zweite Hauptfläche (26) und einen zur Erzeugung von Strahlung vorgesehenen aktiven Bereich (23) aufweist;
- einem Träger (5), an dem der Halbleiterchip (2) seitens der zweiten Hauptfläche (26) befestigt ist;
- einer Auskoppelschicht (4), die auf der ersten Hauptfläche (25) des Halbleiterchips (2) angeordnet ist und eine in lateraler Richtung von dem Halbleiterchip (2) beabstandete seitliche Auskoppelfläche (40) bildet,
wobei
- in der Auskoppelschicht (4) eine sich zum Halbleiterchip hin verjüngende Ausnehmung (45) ausgebildet ist, die sich in vertikaler Richtung durch die Auskoppelschicht hindurch erstreckt und im Betrieb aus der ersten Hauptfläche (25) austretende Strahlung in Richtung der seitlichen Auskoppelfläche (40) umlenkt;
- auf der Auskoppelschicht eine erste Kontaktstruktur (61) ausgebildet ist, die den Halbleiterchip durch die Ausnehmung in der Auskoppelschicht hindurch seitens der ersten Hauptfläche elektrisch kontaktiert;
- der Halbleiterchip in lateraler Richtung zumindest bereichsweise von einer Reflektorschicht (31) umgeben ist;
dadurch charakterisiert, dass
- die Reflektorschicht elektrisch isolierend ist und zumindest bereichsweise unmittelbar an den Halbleiterchip angrenzt.

2. Strahlungsemittierendes Bauelement nach Anspruch 1,
wobei auf einer der Reflektorschicht abgewandten Seite der Auskoppelschicht eine weitere Reflektorschicht (32) angeordnet ist.

3. Strahlungsemittierendes Bauelement nach Anspruch 2,
wobei mittels der Reflektorschicht und der weiteren Reflektorschicht vermieden wird, dass in die Auskoppelschicht eingekoppelte Strahlung in vertikaler Richtung aus dem Bauelement austritt.

4. Strahlungsemittierendes Bauelement nach Anspruch 2 oder 3,
wobei die Reflektorschicht und die weitere Reflektorschicht in einem an die Auskoppelfläche angrenzenden Bereich parallel zueinander verlaufen.

5. Strahlungsemittierendes Bauelement nach einem der Ansprüche 2 bis 4,
wobei eine dem Halbleiterchip zugewandte Schicht der ersten Kontaktstruktur die weitere Reflektorschicht bildet.

6. Strahlungsemittierendes Bauelement nach einem der Ansprüche 1 bis 5,
wobei die Ausnehmung in Aufsicht auf das Bauelement trichterförmig ausgebildet und mittig zum Halbleiterchip angeordnet ist.

7. Strahlungsemittierendes Bauelement nach einem der Ansprüche 1 bis 6,
wobei die seitliche Auskoppelfläche in Aufsicht auf das Bauelement zumindest bereichsweise gekrümmt ist.

8. Bauelementanordnung mit einer Mehrzahl von Bauelementen gemäß einem der Ansprüche 1 bis 7,
bei der zumindest ein erstes Bauelement (1A) und ein zweites Bauelement (1B) in vertikaler Richtung übereinander angeordnet sind.

9. Bauelementanordnung nach Anspruch 8,
bei der das erste und das zweite Bauelement jeweils auf der dem Halbleiterchip (2) abgewandten Seite der jeweiligen Auskoppelschicht (4) eine erste Kontaktstruktur (61) und auf der der ersten Kontaktstruktur gegenüberliegenden Seite des jeweiligen Bauelements eine zweite Kontaktstruktur (62) aufweisen, wobei die erste Kontaktstruktur des ersten Bauelements mit der zweiten Kontaktstruktur des zweiten Bauelements elektrisch leitend verbunden ist.

10. Bauelementanordnung nach Anspruch 8,
bei der das erste und das zweite Bauelement jeweils eine erste Kontaktstruktur (61) und eine zweite Kontaktstruktur (62) aufweisen, die zur Injektion von Ladungsträgern in den aktiven Bereich (23) aus entgegengesetzten Richtungen vorgesehen sind, wobei sich die erste Kontaktstruktur und die zweite Kontaktstruktur in vertikaler Richtung jeweils durch den Träger (5) und durch die Auskoppelschicht (4) hindurch erstrecken.

11. Bauelementanordnung mit einer Mehrzahl von Bauelementen gemäß einem der Ansprüche 1 bis 7,
bei der zumindest ein erstes Bauelement (1A) und ein zweites Bauelement (1B) in lateraler Richtung nebeneinander angeordnet sind, wobei die Bauelementanordnung Kontaktbahnen (81) aufweist, die auf gegenüberliegenden Seiten der Bauelemente angeordnet sind und die Bauelemente elektrisch parallel zueinander verschalten.

12. Bauelementanordnung mit einer Mehrzahl von Bauelementen gemäß einem der Ansprüche 1 bis 7,
bei der die Bauelemente zwischen zwei Platten (8) angeordnet sind, wobei zumindest eine der Platten für die in den Bauelementen erzeugte Strahlung transparent oder zumindest transluzent ist.

13. Verfahren zur Herstellung einer Mehrzahl von strahlungsemittierenden Bauelementen (1) mit den Schritten:
a) Anordnen einer Mehrzahl von Halbleiterchips (2) auf einem Träger (5);
b) Aufbringen einer Reflektorschicht (31) in die Zwischenräume (55) zwischen den Halbleiterchips, wobei die Reflektorschicht elektrisch isolierend ist und zumindest bereichsweise unmittelbar an die Halbleiterchips angrenzt;
c) Ausbilden einer Auskoppelschicht (4) mit Ausnehmungen (25), in denen jeweils ein Halbleiterchip freigelegt ist und die sich zum Halbleiterchip hin verjüngen und ausbilden einer Kontaktstruktur (61), die den Halbleiterchip durch die Ausnehmung in der Auskoppelschicht elektrisch kontaktiert; und
d) Vereinzeln in die Mehrzahl von Bauelementen, wobei die Auskoppelschicht durchtrennt wird und jedes Bauelement zumindest einen Halbleiterchip und eine Ausnehmung in der Auskoppelschicht aufweist.

14. Verfahren nach Anspruch 13,
bei dem die Ausnehmungen mittels kohärenter Strahlung ausgebildet werden.

## Claims

1. A radiation-emitting component (1), comprising
- a semiconductor chip (2), which has a first main surface (25), a second main surface (26) on the opposite side from the first main surface (25) and an active region (23) provided for the generation of radiation;
- a carrier (5), on which the semiconductor chip (2) is fixed on the side of the second main surface (26);
- an output layer (4), which is arranged on the first main surface (25) of the semiconductor chip (2) and forms a lateral output surface (40) which is spaced apart from the semiconductor chip (2) in the lateral direction,
wherein
- a recess (45) tapering in the direction of the semiconductor chip is formed in the output layer (4), the recess extending through the output layer in vertical direction and deflecting radiation emerging from the first main surface (25) during operation into the direction of the lateral output surface (40);
- a first contact structure (61) is formed on the output layer, the first contact structure electrically contacting the semiconductor chip through the recess in the output layer on the side of the first main surface;
- the semiconductor chip is at least locally surrounded by a reflector layer (31) in the lateral direction;
**characterized in that**
- the reflector layer is electrically insulating and at least locally directly adjoins the semiconductor chip.

2. The radiation-emitting component according to claim 1,
wherein a further reflector layer (32) is arranged on an opposite side of the output layer from the reflector layer.

3. The radiation-emitting component according to claim 2,
wherein by means of the reflector layer and the further reflector layer radiation introduced into the output layer is prevented from emerging from the component in the vertical direction.

4. The radiation-emitting component according to claim 2 or 3,
wherein the reflector layer and the further reflector layer extend parallel to one another in a region adjacent to the output surface.

5. The radiation-emitting component according to one of claims 2 to 4,
wherein a layer of the first contact structure facing the semiconductor chip forms the further reflector layer.

6. The radiation-emitting component according to one of claims 1 to 5,
wherein the recess is formed in the shape of a funnel in plan view on the component and is arranged centrally with respect to the semiconductor chip.

7. The radiation-emitting component according to one of claims 1 to 6,
wherein the lateral output surface is at least locally curved in plan view on the component.

8. A component arrangement comprising a multiplicity of components according to one of claims 1 to 7,
wherein at least a first component (1A) and a second component (1B) are arranged above one another in the vertical direction.

9. The component arrangement according to claim 8,
wherein the first and second components respectively have a first contact structure (61) on the opposite side of the respective output layer (4) from the semiconductor chip (2) and a second contact structure (62) on the opposite side of the respective component from the first contact structure, the first contact structure of the first component being electrically conductively connected to the second contact structure of the second component.

10. The component arrangement according to claim 8,
wherein the first and second components respectively have a first contact structure (61) and a second contact structure (62), which are provided for the injection of charge carriers into the active region (23) from opposite directions, the first contact structure and the second contact structure extending in the vertical direction respectively through the carrier (5) and through the output layer (4).

11. A component arrangement comprising a multiplicity of components according to one of claims 1 to 7,
wherein at least a first component (1A) and a second component (1B) are arranged next to one another in the lateral direction, the component arrangement having contact tracks (81) which are arranged on opposite sides of the components and electrically interconnect the components in parallel with one another.

12. A component arrangement comprising a multiplicity of components according to one of claims 1 to 7,
wherein the components are arranged between two plates (8), at least one of the plates being transparent or at least translucent for the radiation generated in the components.

13. A method for producing a multiplicity of radiation-emitting components (1), comprising the steps:
a) arranging a multiplicity of semiconductor chips (2) on a carrier (5);
b) applying a reflector layer (31) into the intermediate spaces (55) between the semiconductor chips, wherein the reflector layer is electrically insulating and at least locally is directly adjacent to the semiconductor chip;
c) forming an output layer (4) comprising recesses (25) in which a semiconductor chip is respectively exposed and which taper in the direction of the semiconductor chip and forming a contact structure (61) electrically contacting the semiconductor chip through the recess in the output layer; and
d) singulation into the multiplicity of components, the output layer being cut through and each component having at least one semiconductor chip and one recess in the output layer.

14. The method according to claim 13,
wherein the recesses are formed by means of coherent radiation.

## Revendications

1. Composant (1) émetteur de rayonnement comprenant
- une puce à semi-conducteur (2) qui présente une première surface principale (25), une deuxième surface principale (26) opposée à la première surface principale (25) et une zone active (23) ménagée pour générer le rayonnement ;
- un support (5) sur lequel la puce à semi-conducteur (2) est fixée du côté de la deuxième surface principale (26) ;
- une couche de découplage (4) qui est disposée sur la première surface principale (25) de la puce à semi-conducteur (2) et forme une surface de découplage (40) latérale, distancée de la puce à semi-conducteur (2) en direction latérale,
- un évidement (45) se rétrécissant en direction de la puce à semi-conducteur étant réalisé dans la couche de découplage (4), lequel s'étend en direction verticale en traversant la couche de découplage et, en fonctionnement, dévie le rayonnement sortant de la première surface principale (25) en direction de la surface de découplage (40) latérale ;
- une première structure de contact (61) étant réalisée sur la couche de découplage, laquelle met en contact électrique la puce à semi-conducteur à travers l'évidement situé dans la couche de découplage du côté de la première surface principale ;
- la puce à semi-conducteur étant entourée au moins en partie d'une couche réfléchissante (31) en direction latérale ;
**caractérisé en ce que**
- la couche réfléchissante est électriquement isolante et est directement adjacente, au moins en partie, à la puce à semi-conducteur.

2. Composant émetteur de rayonnement selon la revendication 1, une couche réfléchissante supplémentaire (32) étant disposée sur un côté de la couche de découplage, détourné de la couche réfléchissante.

3. Composant émetteur de rayonnement selon la revendication 2, la couche réfléchissante et la couche réfléchissante supplémentaire permettant d'éviter que le rayonnement couplé dans la couche réfléchissante ne sorte du composant en direction verticale.

4. Composant émetteur de rayonnement selon la revendication 2 ou 3, la couche réfléchissante et la couche réfléchissante supplémentaire s'étendant parallèlement l'une à l'autre dans une zone adjacente à la surface de découplage.

5. Composant émetteur de rayonnement selon l'une quelconque des revendications 2 à 4,
une couche de la première structure de contact, tournée vers la puce à semi-conducteur, formant la couche réfléchissante supplémentaire.

6. Composant émetteur de rayonnement selon l'une quelconque des revendications 1 à 5,
l'évidement, en vue de dessus sur le composant, étant réalisé en forme d'entonnoir et étant disposé de manière centrale par rapport à la puce à semi-conducteur.

7. Composant émetteur de rayonnement selon l'une quelconque des revendications 1 à 6,
la surface de découplage latérale, en vue de dessus sur le composant, étant courbée au moins en partie.

8. Agencement de composants comprenant une pluralité de composants selon l'une quelconque des revendications 1 à 7, dans lequel au moins un premier composant (1A) et un deuxième composant (1B) sont disposés les uns sur les autres en direction verticale.

9. Agencement de composants selon la revendication 8,
dans lequel le premier et le deuxième composants présentent respectivement sur le côté de la couche de découplage respective (4), détourné de la puce à semi-conducteur (2), une première structure de contact (61) et une deuxième structure de contact (62) sur le côté du composant respectif, opposé à la première structure de contact, la première structure de contact du premier composant étant reliée de manière électro-conductrice à la deuxième structure de contact du deuxième composant.

10. Agencement de composants selon la revendication 8,
dans lequel le premier et le deuxième composants présentent respectivement une première structure de contact (61) et une deuxième structure de contact (62), lesquelles sont ménagées pour injecter des porteurs de charges dans la zone active (23) à partir de directions opposées, la première structure de contact et la deuxième structure de contact s'étendant respectivement en traversant le support (5) et la couche de découplage (4).

11. Agencement de composants comprenant une pluralité de composants selon l'une quelconque des revendications 1 à 7, dans lequel au moins un premier composant (1A) et un deuxième composant (1B) sont disposés les uns à côté des autres en direction latérale, l'agencement de composants présentant des pistes de contact (81) qui sont disposées sur des côtés opposés des composants et connectent les composants électriquement de manière parallèle les uns aux autres.

12. Agencement de composants comprenant une pluralité de composants selon l'une quelconque des revendications 1 à 7, dans lequel les composants sont disposés entre deux plaques (8), au moins une des plaques étant transparente ou au moins translucide pour le rayonnement généré dans les composants.

13. Procédé de fabrication d'une pluralité de composants (1) émettant un rayonnement, comprenant les étampes :
a) disposition d'une pluralité de puces à semi-conducteur (2) sur un support (5) ;
b) application d'une couche réfléchissante (31) dans les espaces intermédiaires (55) situés entre les puces à semi-conducteur, la couche réfléchissante étant électriquement isolante et étant directement adjacente, au moins en partie, aux puces à semi-conducteur ;
c) formation d'une couche de découplage (4) avec des évidements (25) dans lesquels une puce à semi-conducteur est respectivement dégagée, et lesquels se rétrécissent en direction de la puce à semi-conducteur, et formation d'une structure de contact (61) qui met en contact électrique la puce à semi-conducteur à travers l'évidement situé dans la couche de découplage
et
d) séparation dans la pluralité de composants, la couche de découplage étant détachée et chaque composant présentant au moins une puce à semi-conducteur et un évidement dans la couche de découplage.

14. Procédé selon la revendication 13,
dans lequel les évidements sont réalisés par rayonnement cohérent.
